Europäisches Patentamt

European Patent Office

Office européen des brevets

(11) Publication number: **0 081 554**

**B1**

(12) **EUROPEAN PATENT SPECIFICATION**

(45) Date of publication of patent specification: **22.02.89**

(51) Int. Cl.⁴: **H 01 L 33/00**

(21) Application number: **82902000.7**

(22) Date of filing: **03.05.82**

(86) International application number:
**PCT/US82/00589**

(87) International publication number:
**WO 82/04500 23.12.82 Gazette 82/30**

(54) **LED HAVING SELF-ALIGNED LENS.**

(30) Priority: **12.06.81 US 272822**

(43) Date of publication of application:
**22.06.83 Bulletin 83/25**

(45) Publication of the grant of the patent:
**22.02.89 Bulletin 89/08**

(84) Designated Contracting States:
**DE FR GB NL**

(56) References cited:
**FR-A-2 440 563**
**US-A-3 764 862**
**US-A-3 816 847**
**US-A-3 834 883**
**US-A-3 932 881**
**US-A-4 329 190**

**IEEE TRANSACTIONS ON ELECTRON
DEVICES, vol. ED-24, no. 7, July 1977, NEW
YORK (US) S. HORIUCHI et al.: "A new LED
structure with a self-aligned sphere lens for
efficient coupling to optical fibers", pages
986-990**

(73) Proprietor: **MOTOROLA, INC.**
**1303 East Algonquin Road
Schaumburg Illinois 60196 (US)**

(72) Inventor: **MITCHELL, Curtis W.
2909 W. Butler
Phoenix, AZ 85021 (US)**
Inventor: **BERG, Howard M.
12017 N. 84th Street
Scottsdale, AZ 85260 (US)**

(74) Representative: **Ibbotson, Harold et al
Motorola Ltd Patent and Licensing Operations -
Europe Jays Close Viables Industrial Estate
Basingstoke Hampshire RG22 4PD (GB)**

(56) References cited:
**PROCEEDINGS IEEE, vol. 66, no. 2, February
1978, NEW YORK (US) S. HORIUCHI et al.: "A
monolithic linear array of high-radiance
A1GaAs double heterostructure LES's with
self-aligned spherical lenses"**

**PATENTS ABSTRACTS OF JAPAN, vol. 5, no.
103, (E-64) (775), July 3, 1981
Electronics, Vol. 52, No. 11, 24 May 1979, pp.
73-74. Note Fig. 3.**

# Description

## Background of the Invention

This invention relates to electro-optical devices having a photo-active area such as light emitting diodes (LEDs) and photodetectors and, in particular, to LEDs and photodetectors having an integral lens. As used herein, "light" refers to electromagnetic radiation which semiconductor material can be caused to emit or detect, whether or not such emission is visible to the unaided human eye.

A number of LED devices have been proposed in the prior art in which a lens is attached or located adjacent the light emitting area of the diode. Since the lens has an approximate focal zone, it is important that the lens be accurately located so that the focal zone coincides with the emitting area of the diode. This entails a careful positioning of the lens in three dimensions. In one proposed method, as shown in French Patent Application FR-A-2 440 565 a lens is secured on a polyimide flexible substrate having an aperture. The substrate is then moved about while the LED is turned on in order to find the optimum position for the lens at which time the substrate is fixed. This approach is tedious, time consuming, and costly. Further, since even slight lateral displacement (parallel to the plane of the emitting area) causes large changes in the amount of light coupled, performance specifications of the LED are difficult to achieve consistently. A smaller, but not insignificant, variation is caused by variation from device to device in thickness of the substrate. An alternative procedure is to align the lens visually over the device's emission area.

In IEEE Transactions on Electron Devices, Vol. ED-24, No. 7, July 1977, pages 986 to 990 there is disclosed an LED structure comprising an integrated positioning means for holding and automatically locating a spherical lens laterally with respect to a photo-active area. It does not however position the lens in the vertical direction with respect to the photo-active area.

It is, therefore, an object of the present invention to provide an LED having a lens accurately located in three dimensions with respect to the emitting area of the diode.

Another object of the present invention is to provide an easily assembled LED having a lens.

A further object of the present invention is to provide an improved method for manufacturing LED's with lenses.

Another object of the present invention is to provide an improved LED structure so that lenses can be attached prior to the diodes being separated from the wafer.

## Summary of the Invention

Accordingly, the invention provides an electro-optical semiconductor device comprising a semiconductive substrate having a photo-active area; a lens adjacent said photo-active area; and positioning means between said lens and said semiconductive substrate for holding said lens adjacent said photo-active area, characterised in that said positioning means is formed directly on said semiconductive substrate and has such a shape and thickness as to define an aperture coincident with said photo-active area whereby said lens is automatically located in the desired position both laterally adjacent to and vertically spaced from said photo-active area.

In a preferred embodiment, the positioning means comprises an annular ring whose thickness and aperture may be controlled to provide an accurate spacing between the lens and the emitting area and to laterally locate the lens. The ring may be formed by coating the LED and configuring the coating to leave a ring about the active area. The coating may comprise diverse materials such as metal and/or polymers such as photoresist and polyimides.

A more complete understanding of the present invention can be obtained by considering the following detailed description in conjunction with the accompanying drawings, in which:

## Brief Description of the Drawings

FIGURE 1 illustrates an LED with lens in accordance with the prior art.

FIGURE 2 illustrates a preferred embodiment of an LED with lens in accordance with the present invention.

FIGURE 3 illustrates a sequence of steps for assembling an LED and lens in accordance with the present invention.

FIGURE 4 illustrates a packaged LED in accordance with the present invention.

## Detailed Description of the Invention

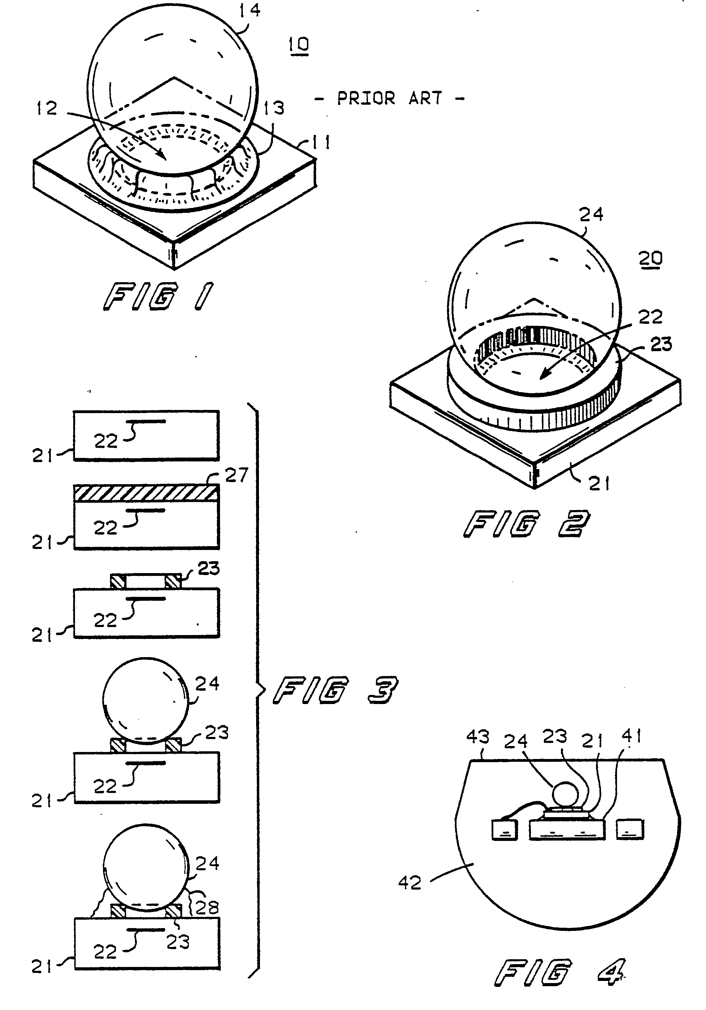

In accordance with the prior art, as illustrated in FIG. 1, a semiconductor body 11 comprises a photo-emitting area 12. Semiconductor body 11 may comprise any suitable material such as gallium arsenide or, more particularly, what is known in the art as a heterojunction device comprising several doped layers of gallium arsenide. As known in the art, the flow of electric current through the junction in these devices causes the "active" layer to emit photons, the energy of which is within a relatively narrow band of frequencies, giving the LED its characteristic color. The electrical leads and connections by which current is caused to flow through the junction have been omitted for clarity.

Since the emission of photons by emitting area 12 is characterized by what is known as Lambertian emission, it is desired to gather as much of the emitted light as possible and redirect it into a preferred direction. To do this a spherical lens 14 is positioned over emitting area 12 and held in place by a suitable adhesive 13. As with any lens, it is extremely important that the photo-emitting area be within the focal zone of the lens. This requires that the lens be accurately positioned with respect to emitting area 12. As illustrated in FIG. 1, emitting area 12 is shown considerably larger than it would be in an actual device. For example, emitting area 12 typically has a diameter of about 50-100 micrometers while spherical lens 14 typically has a diameter of 250 to 380 micrometers. Thus, any lateral misalignment of lens 14 with respect to emitting area 12 causes a considerable decrease in the amount of light gathered by lens 14. In the prior art, adhesive 13 is typically applied to the upper surface of semiconductor device 11 and lens 14 is positioned over emitting area 12. Lens 14 is then held in place until adhesive 13 has cured sufficiently to maintain the alignment of lens 14. Lens 14 is typically aligned with emitting area 12 either visually or by passing a current through the device and monitoring the light output. The former technique is inaccurate while the latter technique is time consuming and costly, and is subject to problems of consistency since the alignment is being done by hand.

In accordance with the present invention, as illustrated in FIG. 2, light emitting semiconductor 21 having light emitting area 22 is provided with step 23 surrounding light emitting area 22. Step 23 is formed by depositing layer over the upper surface of semiconductor 21 and then patterning and etching the layer. Since step 23 is formed with light emitting semiconductor 21 using precise optical techniques, the alignment of ring 23 with light emitting area 22 is quite accurate and subject to the same tolerances as for the formation of light emitting area 22. Lens 24 is then readily located by step 23 and is accurately positioned laterally with respect to emitting area 22 as well as being accurately spaced therefrom. Inserting lens 24 into the center portion of step 23 requires little precision and does not require the activation of the LED. Thus, the LED and lens can be assembled in batch form, i.e. requiring the handling of wafers rather than individual die. This further simplifies the assembly of an LED and lens and further decreases the cost of the assembly.

Lens 24 can have any suitable lenticular shape and comprise any transparent, high index of refraction material which will not contaminate the diode. Suitable materials include glass and minerals such as sapphire and GaP. In a preferred embodiment of the present invention, spherical glass beads are used since they are abundantly available at relatively low cost.

As illustrated in detail in FIG. 3, device 21 with photo-active area 22 is covered by one or more layers 27 which are then patterned and etched to form step 23. Lens 24 is then rested on step 23 and automatically aligned and separated from emitting area 22 by step 23. Finally, a suitable adhesive 28, such as GE-261 or Hysol OS-1600, is disposed about step 23 to secure lens 24 to step 23 and to light emitting semiconductor device 21. The adhesive is then cured by the application of heat.

An additional advantage in the structure of the present invention can be obtained by interchanging the last two process steps. Specifically, uncured adhesive 28 is first applied over and about step 23 and then lens 24 is brought into contact with adhesive 28. Since surface tension forces in adhesive 28 considerably exceed the weight of lens 24, a self-centering action takes place whereby the adhesive positions and holds lens 24 in a central location with respect to step 23. This technique further adapts the present invention to batch handling of devices rather than individual handling of devices. Despite such simplification, however, lens 24 is much more accurately and consistently aligned with emitting area 22 than has been obtainable in the prior art.

Layer 27 may comprise any suitable material, for example, a metal layer, a thick layer of photoresist, or both. If layer 27 is in the form of a ring or other closed figure, it is preferred that thick metal not contact the semiconductor surface due to the large difference in thermal coefficients of expansion between most common metals and the semiconductor. Any thick photoresist material can be used for layer 27. For example, a photo polymer film resist sold under the tradename "RISTON" by E.I. DuPont de Nemours & Co. has been found suitable for use in the present invention. For example, following the manufacturer's directions, a 0.1 mm layer of Riston is applied to semiconductor 21 and patterned to form step 23.

FIGURE 4 illustrates a complete device in what is known as a TO-92 type package. Specifically, header 41 comprises a formed metal blank having appropriate leads adjacent thereto which provides support and electrical and thermal contact to semiconductor die 21. Semiconductor die 21 is attached to header 41 by any suitable means, e.g. soft or hard solder or conductive epoxy. As known in the art, if it is desired to electrically isolate die 21 from header 41, a wafer of electrically insulating ceramic, such as beryllium oxide, can be interposed between the die and header. Step 23 on die 21 locates and separates lens 24 from die 21. Surrounding and enclosing die 21 and lens 24 is encapsulant 42, preferably comprising a colorless polymer, having flat surface 43 which acts as a window.

In operation, current through the LED causes light to be emitted. The light radiating upward is gathered by lens 24 and projected through surface 43. This light is viewed or used directly or can be coupled into an optical fiber transmission line for use at a remote location.

It will be apparent that one need not completely etch away layer 27 to form step 23 in the shape of an annular ring, but could simply form the central aperture only, leaving the rest of the layer as a protective coating. Further, the alignment and spacing need not be accomplished by use of a closed geometry since, as known per se in the art, only three supporting points are actually necessary to space and align lens 24. However, particularly for gallium arsenide devices, the crystal structure of the light emitting diode is sensitive to dislocations. Only three supporting points may cause excessive stress in the gallium arsenide. Step 23 in the form of a ring provides a protective function as well in spacing lens 24 away from the surface of semiconductor 21. The LED itself may comprise either planar or "etched well" devices, although planar devices are preferred at present. While described in a preferred embodiment as a light emitting device, the present invention can also be embodied in light detecting devices. Also, depending on the adhesive chosen, any suitable cure can be effected, e.g. thermal or actinic radiation.

## Claims

1. An electro-optical semiconductor device (20) comprising:

a semiconductive substrate (21) having a photo-active area (22);

a lens (24) adjacent said photo-active area (22); and

positioning means (23) between said lens (24) and said semiconductive substrate (21) for holding said lens (24) adjacent said photo-active area characterised in that said positioning means is formed directly on said semiconductive substrate and has such a shape and thickness as to define an aperture coincident with said photo-active area whereby said lens is automatically located in the desired position both laterally adjacent to and vertically spaced from said photo-active area.

2. The device as set forth in claim 1 wherein said positioning means comprises an annular ring.

3. The device as set forth in claim 2 wherein said ring comprises photoresist polymer.

4. The device as set forth in claim 2 wherein said ring comprises a metal layer.

5. The device as set forth in claim 1 wherein said lens comprises a spherical lens.

6. The device as set forth in claim 5 wherein said lens comprises glass.

7. The device as set forth in claim 1 and further comprising adhesive means for attaching said lens to said positioning means.

8. A method of manufacturing electro-optical semiconductor devices (20), each device comprising a semiconductive substrate (21) having a photo-active area (22) and a lens (24) adjacent said photo-active area (22), characterised in that the method comprises the steps of:

forming a layer (27) of predetermined thickness on said substrate;

configuring said layer to form an aperture at least as large as, and coincident with, said photo-active area and to automatically define the desired location of said lens; and

attaching said lens to said device by locating said lens in said aperture.

9. The method as set forth in claim 8 wherein said attaching step includes the step of securing the lens to said device with adhesive.

10. The method as set forth in claim 8 wherein said attaching step comprises the steps of:

depositing adhesive on said layer;

contacting said adhesive with said lens whereby surface tension forces cause a self-centering of the lens over said area; and

gelling said adhesive thereby locking the lens in position over the photo-active area.

## Patentansprüche

1. Elektro-optische Halbleitereinrichtung (20), enthaltend:

ein halbleitendes Substrat (21), das eine fotoaktive Fläche (22) aufweist,

eine Linse (24) benachbart der fotoaktiven Fläche (22), und

eine Positioniereinrichtung (23) zwischen der Linse (24) und dem halbleitenden Substrat (21), um die Linse (24) benachbart der fotoaktiven Fläche zu halten, dadurch gekennzeichnet, daß die Positioniereinrichtung direkt auf dem halbleitenden Substrat ausgebildet ist und eine solche Gestalt und Dicke aufweist, daß eine Öffnung ausgebildet wird, die mit der fotoaktiven Fläche zusammenfällt, wodurch die Linse automatisch in der gewünschten Position sowohl quer benachbart zu und vertikal im Abstand von der fotoaktiven Fläche gelegen ist.

2. Einrichtung nach Anspruch 1, bei der die Positioniereinrichtung ein ringförmiger Ring ist.

3. Einrichtung nach Anspruch 2, bei der der Ring ein Fotoresist-Polymer enthält.

4. Einrichtung nach Anspruch 2, bei der der Ring eine Metallschicht enthält.

5. Einrichtung nach Anspruch 1, bei der die Linse eine sphärische Linse ist.

6. Einrichtung nach Anspruch 5, bei der die Linse aus Glas besteht.

7. Einrichtung nach Anspruch 1 und weiterhin enthaltend einen Klebstoff zum Befestigen der Linse auf der Positioniereinrichtung.

8. Verfahren zum Herstellen elektro-optischer Halbleitereinrichtungen (20), wobei jede Einrichtung ein halbleitendes Substrat (21) mit einer fotoaktiven Fläche (22) und eine Linse (24) benachbart der fotoaktiven Fläche (22) aufweist, dadurch gekennzeichnet, daß das Verfahren die folgenden Schritte enthält:

Ausbilden einer Schicht (27) vorbestimmter Dicke auf dem Substrat,

Gestalten der Schicht derart, daß eine Öffnung gebildet wird, die wenigstens so groß wie und koinzident mit der genannten fotoaktiven Fläche ist und um automatisch den gewünschten Ort für die Linse zu bestimmen, und

Befestigen der Linse an der Einrichtung durch Anbringen der Linse in der Öffnung.

9. Verfahren nach Anspruch 8, bei dem der Befestigungsschritt das Befestigen der Linse an der Einrichtung mit Klebstoff umfaßt.

10. Verfahren nach Anspruch 8, bei der der Befestigungsschritt die folgenden Schritte umfaßt:

Aufbringen eines Klebstoffs auf der Schicht,

Kontaktieren des Klebstoffs mit der Linse, wodurch die Oberflächenspannung Selbstzentrierungskräfte der Linse über der genannten Fläche hervorruft, und

Gelieren des Klebstoffs, um dadurch die Linse in Position über der fotoaktiven Fläche zu befestigen.

## Revendications

1. Dispositif semi-conducteur électro-optique (20) comportant:

un substrat semi-conducteur (21) avec une région photo-active (22);

une lentille (24) voisine de ladite région photo-active (22); et

un dispositif de positionnement (23) entre ladite lentille (24) et ledit substrat semi-conducteur (21) pour maintenir ladite lentille (24) voisine de ladite région photo-active, caractérisé en ce que ledit dispositif de positionnement est formé directement sur ledit substrat semi-conducteur et a une forme et une épaisseur telles qu'elles définissent une ouverture qui coïncide avec ladite région photo-active, de manière que ladite lentille soit automatiquement positionnée dans la position voulue, à la fois voisine latéralement et espacée verticalement de ladite région photo-active.

2. Dispositif selon la revendication 1, dans lequel ledit dispositif de positionnement consiste en une bague annulaire.

3. Dispositif selon la revendication 2, dans lequel ladite bague consiste en un polymère photosensible.

4. Dispositif selon la revendication 2, dans lequel ladite bague consiste en une couche métallique.

5. Dispositif selon la revendication 1, dans lequel ladite lentille consiste en une lentille sphérique.

6. Dispositif selon la revendication 5, dans lequel ladite lentille est en verre.

7. Dispositif selon la revendication 1, comportant en outre un dispositif adhésif pour fixer ladite lentille sur ledit dispositif de positionnement.

8. Procédé de fabrication de dispositifs semiconducteurs électro-optiques (20), chaque dispositif comportant un substrat semi-conducteur (21) avec une région photo-active (22) et une lentille (24) voisine de ladite région photo-active (22), procédé caractérisé en ce qu'il consiste:

à former une couche (27) d'une épaisseur prédéterminée sur ledit substrat;

à configurer ladite couche pour former une ouverture au moins aussi grande que ladite région photo-active et coïncidant avec elle et pour définir automatiquement la position voulue de ladite lentille; et

à fixer ladite lentille sur ledit dispositif en positionnant ladite lentille dans ladite ouverture.

9. Procédé selon la revendication 8, dans lequel ladite opération de fixation consiste à fixer la lentille sur ledit dispositif avec un adhésif.

10. Procédé selon la revendication 8, dans lequel ladite opération de fixation consiste:

à déposer un adhésif sur ladite couche;

à mettre en contact ledit adhésif avec ladite lentille de manière que des forces de tension superficielle entraînent un auto-centrage de la lentille sur ladite région; et

à durcir ledit adhésif, bloquant ainsi la lentille en position au-dessus de la région photo-active.

FIG 1

– PRIOR ART –

FIG 2

FIG 3

FIG 4